# EUROPÄISCHE PATENTSCHRIFT

(11) **EP 3 068 655 B1**
(45) Veröffentlichungstag und Bekanntmachung des Hinweises auf die Patenterteilung: **30.09.2020**
(21) Anmeldenummer: 14799984.1
(22) Anmeldetag: 10.11.2014
(51) Int. Cl.: B60K 37/06

(54) **BEDIENEINHEIT**
OPERATING UNIT
UNITÉ DE COMMANDE

(30) Priorität: 11.11.2013 DE 102013222940
(43) Veröffentlichungstag der Anmeldung: 21.09.2016
(73) Patentinhaber: Continental Automotive GmbH, 30165 Hannover (DE)
(72) Erfinder: KAYSSER, Sascha, 63477 Maintal (DE)
(86) Internationale Anmeldenummer: PCT/EP2014/074180
(87) Internationale Veröffentlichungsnummer: WO 2015/067803

(56) Entgegenhaltungen:
- EP-A1- 2 305 508
- WO-A1-2013/053529

## Beschreibung

### Technisches Gebiet

Die Erfindung betrifft eine Bedieneinheit eines Fahrzeugs, ein Fahrzeug und ein Verfahren.

### Technischer Hintergrund

In der Automobilindustrie können Bedienelemente mit einem kapazitiven Tastfeld für diverse Nutzereingabe-Anwendungen in Fahrzeugen eingesetzt werden. Einerseits können für den Ruhestromverbrauch solcher Bedienelemente vorgegebene Anforderungen gelten. Anderseits kann es erforderlich sein, dass solche Bedienelemente schnell auf eine Benutzereingabe reagieren können.

Für eine schnelle Reaktion auf die Benutzereingabe bzw. auf eine Berührung gegebenenfalls mit einer Klassifizierung der Benutzereingabe auf Gültigkeit bzw. Ungültigkeit und für die Auswertung der Benutzereingabe sollte üblicherweise eine Auswerteelektronik in einem aktiven Betriebszustand sein. Dabei kann die Auswerteelektronik ein Sensorfeld und einen Mikrokontroller zur Steuerung des Sensorfelds aufweisen. Gegebenenfalls kann noch ein Hauptmikrokontroller aktiv sein, um weiterführende Benutzereingaben direkt auswerten zu können. Aus diesen aktiven Komponenten kann ein erhöhter Stromverbrauch erfolgen.

Die WO 2009/147062 beschreibt ein Detektionssystem zur Annäherungserkennung, wobei eine Fernbereichsdetektion mittels eines optischen oder akustischen Sensors erfolgt.

Die WO 2013053529 Albeschreibt ein Bediensystem mit einer Anzeige, wobei eine Annäherung von Fingern an die Anzeige mittels Sensoren erfasst wird und dann die Darstellung auf der Anzeige geändert wird. Die EP 2 305 508 A1 beschreibt eine Bedieneinrichtung mit einem Touchscreen, bei dem zusätzliche Sensoren zur Detektion der Annäherung von Körperteilen vorhanden sind. Hierbei wird bei einer erkannten Annäherung die Anzeige des Touchscreens von einem Schlafmodus, bei der die Helligkeit der Anzeige gedimmt ist, in einen Wachmodus umgeschaltet, bei dem die Anzeigehelligkeit gegenüber dem Schlafmodus erhöht ist. Die Steuerung der Bedieneinheit erfolgt durch einen Systemcontroller.

### Zusammenfassung der Erfindung

Es ist Aufgabe der Erfindung, den Stromverbrauch von Bedienelementen von Fahrzeugen zu reduzieren.

Die Aufgabe wird gelöst durch die Gegenstände der unabhängigen Ansprüche. Weiterbildungen und Ausführungsformen sind der nachfolgenden Beschreibung, den Figuren sowie den abhängigen Ansprüchen zu entnehmen.

Ein erster Aspekt der Erfindung betrifft eine Bedieneinheit eines Fahrzeugs gemäß Anspruch. 1.

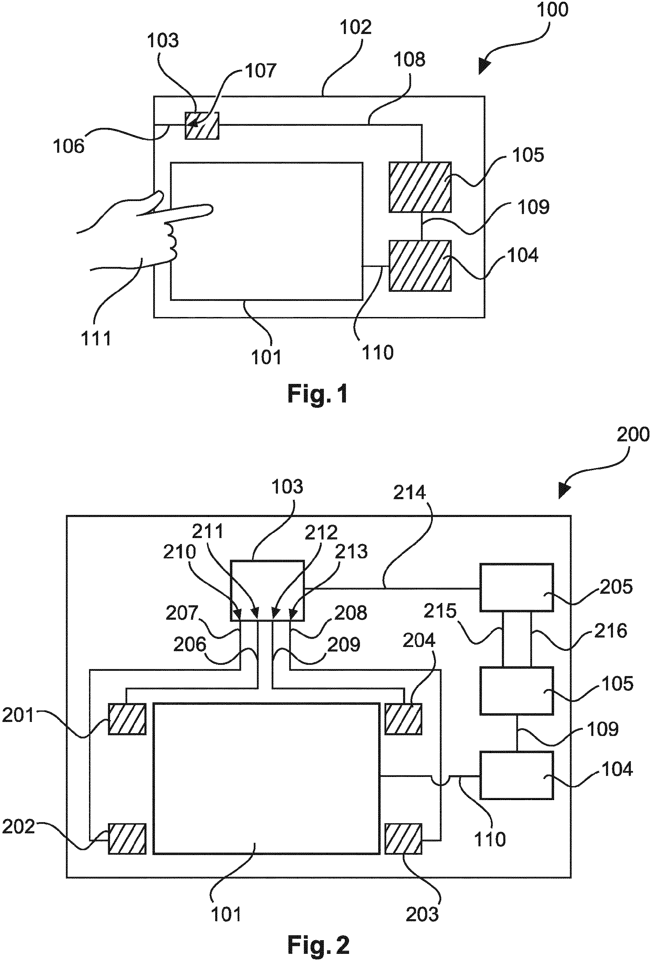

In den Figuren 1 und 2 sind beispielhafte, nicht einschränkende Darstellungen einer solchen Bedieneinheit gezeigt.

Die Bedieneinheit kann also von einem stromsparenden Ruhezustand ohne zusätzliche Benutzereingabe geweckt werden. Somit kann die Bedieneinheit, wenn keine Benutzereingabe erfolgt, einen niedrigen Ruhestrom aufweisen. Wenn die Benutzereingabe dann erfolgt, kann das Tastfeld der Bedieneinheit automatisch geweckt werden, indem die kapazitive Sensoreinheit die Annäherung des Benutzers detektiert und ein Aktivieren des Tastfelds veranlasst. Somit können aus der Bedieneinheit die Vorteile eines geringen Ruhestromverbrauchs und einer Bedienerfreundlichkeit erwachsen, da keine weitere Benutzereingabe zur Aktivierung des Tastfelds erforderlich ist. Mit anderen Worten kann das kapazitive Tastfeld mittels der kapazitiven Sensoreinheit aus einem Ruhezustand bzw. Stand-by-Modus geweckt werden. Dazu kann die kapazitive Sensoreinheit die Annäherung eines Benutzers detektieren und nach der Detektion der Annäherung das kapazitive Tastfeld aus dem Stand-by-Modus wecken. Dabei kann die Annäherung des Benutzers gleichzeitig auch eine Bediengeste des Benutzers zur Benutzereingabe sein. Das heißt, dass der Benutzer mit der Annäherung, die zur Bediengeste auf dem Tastfeld führt, das Tastfeld aktiviert. Auf diese Weise ist keine separate Eingabe bzw. ein separater Knopfdruck des Benutzers zum Aktivieren des Tastfelds erforderlich. Mit anderen Worten kann der Benutzer mit einem einzigen Bewegungsablauf gleichzeitig das Tastfeld aktivieren und auf dem nun aktivierten Tastfeld die Benutzereingabe durchführen. Das Tastfeld kann so ohne zusätzliche Eingabe mit einer einstufigen Bewegung aktiviert werden. Es kann daher ermöglicht werden, dass der Benutzer auf diese Weise durch den Ruhezustand keine Nachteile erfährt.

Unter dem kapazitiven Tastfeld kann dabei ein zweidimensionales Tastfeld verstanden werden, das kapazitiv eine Berührung des kapazitiven Tastfelds oder eine Annäherung an das kapazitive Tastfeld detektiert. Weiterhin kann das kapazitive Tastfeld ausgeführt sein, eine Position der Berührung bzw. der Annäherung zu detektieren. Beispielsweise kann das Tastfeld ein Touchpad oder ein Touchscreen sein. Ferner kann das Tastfeld ausgeführt sein, Mehrfinger-Gesten zu erkennen. Dabei kann unter der Benutzereingabe, die das Tastfeld entgegennehmen kann eine Berührung des Tastfelds durch den Benutzer und/oder eine Annäherung des Benutzers an das Tastfeld verstanden werden. Beispielsweise kann der Benutzer zur Benutzereingabe das Tastfeld mit einem Finger, mit mehreren Fingern, mit einem Stift oder mit anderen Objekten berühren bzw. sich dem Tastfeld mit den genannten Objekten nähern, was durch das Tastfeld erkannt werden kann.

Unter der kapazitiven Sensoreinheit kann eine Sensoreinheit verstanden werden, die ausgeführt ist eine Kapazität zu messen. Die kapazitive Sensoreinheit kann ferner ausgeführt sein Signale zu senden, die von einem Signaleingang der ersten Steuereinheit empfangen werden können. Beispielsweise kann die kapazitive Sensoreinheit zum kontinuierlichen oder regelmäßigen Senden eines eine Kapazität beinhaltenden Signals ausgeführt sein. Die Steuereinheit kann die von der kapazitiven Sensoreinheit gemessene Kapazität überwachen. Ferner kann die erste Steuereinheit als Mikrokontroller ausgeführt sein. Im Falle, dass sich ein Objekt der kapazitiven Sensoreinheit nähert, kann sich die gemessene Kapazität ändern. Auf diese Weise kann mit der ersten Steuereinheit bzw. mit der kapazitiven Sensoreinheit die Annäherung des Benutzers detektiert bzw. erkannt werden. Ferner kann die erste Steuereinheit ausgeführt sein, bei Detektion der Annäherung des Benutzers ein Aufwachsignal an das kapazitive Tastfeld zu senden.

Beispielsweise kann die kapazitive Sensoreinheit ausgeführt sein, die Annäherung des Benutzers in einem Fernbereich des Tastfelds zu detektieren. Das Tastfeld kann ausgeführt sein, eine Berührung oder eine Annäherung in einem Nahbereich des Tastfelds zu detektieren. Dabei kann unter dem Begriff "Annäherung" bzw. "Näherung" verstanden werden, dass der Benutzer in den Fernbereich des Tastfelds eindringt. Der Abstand des Fernbereichs vom Tastfeld kann dabei derart bemessen sein, dass die Steuerung der Bedieneinheit nach der Detektion der Annäherung des Benutzers an das Tastfeld ausreichend Zeit hat, das Tastfeld zu aktivieren. Beispielsweise kann der Abstand so bemessen sein, dass bei einer typischen Bewegungsgeschwindigkeit die Steuerung zumindest 100 ms Zeit hat, das Tastfeld zu aktivieren. Der Fernbereich des Tastfelds hat beispielsweise einen Abstand von 10 cm bis 30 cm zum Tastfeld.

Da die kapazitive Sensoreinheit die Annäherung des Benutzers durch eine Kapazitätsmessung detektieren kann, kann die Annäherung genau detektiert werden. Dabei kann unter "genau" verstanden werden, dass die Position bzw. die Richtung der Annäherung genau bestimmt werden kann und nur eine Annäherung detektiert wird, die in Richtung des Tastfelds gerichtet ist. Ferner kann die Annäherung des Benutzers an das Tastfeld auch von einer anderen Bewegung des Benutzers unterschieden werden, da die kapazitive Sensoreinheit in diesem Fall nur Annäherungen an das Tastfeld und nicht andere Bewegungen des Benutzers detektiert.

Gemäß der Erfindung ist die Bedieneinheit dazu ausgeführt, in einem Ruhezustand der Bedieneinheit das kapazitive Tastfeld zu deaktivieren. Ferner ist die Bedieneinheit ausgeführt, die kapazitive Sensoreinheit und die erste Steuereinheit aktiviert zu lassen.

Dabei kann unter einem Ruhezustand ein Schlafmodus bzw. ein Stand-by-Modus des Tastfelds verstanden werden. Dabei sind im Ruhezustand ein Sensorfeld und eine Steuereinheit des Tastfelds deaktiviert. Auf diese Weise weist die Bedieneinheit im Ruhezustand einen geringen Stromverbrauch auf, d. h. die Bedieneinheit weist einen geringen Ruhestrom auf. Die kapazitive Sensoreinheit und die erste Steuereinheit sind im Ruhezustand weiterhin aktiviert. Mit anderen Worten kann die kapazitive Sensoreinheit im Ruhezustand weiterhin die Annäherung des Benutzers an das Tastfeld detektieren und die erste Steuereinheit kann das Tastfeld aus dem Ruhezustand wecken, wenn die kapazitive Sensoreinheit die Annäherung detektiert. Das heißt, im Ruhezustand sind die zur Detektion der Annäherung und zur Aktivierung des Tastfelds erforderlichen Einheiten aktiviert.

Gemäß der Erfindung weist die Bedieneinheit eine zweite Steuereinheit zum Steuern des kapazitiven Tastfeldes auf. Ferner ist die erste Steuereinheit dazu ausgeführt, zum Aktivieren des kapazitiven Tastfeldes ein Aktivierungssignal an die zweite Steuereinheit zu senden. Die zweite Steuereinheit ist dazu ausgeführt, das kapazitive Tastfeld nach Empfang des Aktivierungssignals zu aktivieren.

Beispielsweise kann die erste Steuereinheit ein Mikrokontroller zur Überwachung des kapazitiven Sensors sein. Die zweite Steuereinheit kann ein Mikrokontroller des Tastfelds sein. Wenn sich der Benutzer dem Tastfeld annähert, kann die erste Steuereinheit detektieren, dass sich die von der kapazitiven Sensoreinheit gemessene Kapazität ändert. In diesem Fall kann die erste Steuereinheit das Aktivierungssignal an die zweite Steuereinheit senden. Da die zweite Steuereinheit des Tastfelds das Aktivierungssignal empfängt, können weitere Komponenten zusammen mit dem Tastfeld aktiviert werden. Beispielsweise kann eine Beleuchtung des Tastfelds aktiviert werden, wenn der Benutzer sich dem Tastfeld nähert.

Gemäß einer weiteren beispielhaften Ausführungsform der Erfindung weist die Bedieneinheit eine Hauptsteuereinheit zum Steuern der Bedieneinheit auf. Die erste Steuereinheit ist dabei dazu ausgeführt, zum Aktivieren des Tastfeldes ein erstes Aktivierungssignal an die Hauptsteuereinheit zu senden. Ferner ist die Hauptsteuereinheit dazu ausgeführt, nach Empfang des ersten Aktivierungssignals ein zweites Aktivierungssignal an eine zweite Steuereinheit zu senden und die zweite Steuereinheit ist ausgeführt, nach Empfang des zweiten Aktivierungssignals das Tastfeld zu aktivieren.

Auf diese Weise kann auch die zweite Steuereinheit in einen Ruhezustand versetzt werden und aus diesem wieder aktiviert werden. Dadurch kann der Ruhestrom der Bedieneinheit weiter reduziert werden.

Gemäß einer weiteren beispielhaften Ausführungsform der Erfindung werden die erste Steuereinheit und die kapazitive Sensoreinheit zusammen mit einem Ruhestrom betrieben, der kleiner oder gleich 100 µA ist. Das kapazitive Tastfeld weist einen Stromverbrauch auf, der größer oder gleich 1 mA ist.

Auf diese Weise kann die Bedieneinheit Anforderungen bezüglich des Ruhestromverbrauchs von Bedieneinheiten in Fahrzeugen erfüllen. Wenn das Tastfeld aktiv ist, kann es mit ausreichend elektrischem Strom betrieben werden, so dass eine Benutzereingabe genau erkannt werden kann.

Gemäß einer weiteren beispielhaften Ausführungsform der Erfindung ist die die kapazitive Sensoreinheit als Leiterschleife ausgeführt.

Dabei kann die Leitschleife ausgeführt sein, eine Kapazität der Leiterschleife zur Erde zu messen. Ferner kann die als Leiterschleife ausgeführte, kapazitive Sensoreinheit um das kapazitive Tastfeld herum angeordnet sein. Außerdem kann die Leiterschleife auch neben dem Tastfeld angeordnet sein. Auf diese Weise kann die kapazitive Sensoreinheit flexibel angeordnet werden. Dadurch kann der Bereich, in welchem die Annäherung detektiert durch die Leiterschleife werden soll, genau konfiguriert werden. Die erste Steuereinheit kann dazu ausgeführt sein, eine von der Leiterschleife gemessene Kapazität zu überwachen und ein Aktivierungssignal an das kapazitive Tastfeld zu senden, wenn die von der kapazitiven Sensoreinheit gemessene Kapazität einen vorbestimmten Wert überschreitet.

Gemäß einer weiteren beispielhaften Ausführungsform der Erfindung ist das kapazitive Tastfeld innerhalb der Leiterschleife angeordnet.

Mit anderen Worten kann die Leiterschleife der kapazitiven Sensoreinheit außerhalb einer Umrandung des kapazitiven Tastfelds angeordnet sein. Auf diese Weise kann für das gesamte Tastfeld die Annäherung detektiert werden.

Gemäß einer weiteren beispielhaften Ausführungsform der Erfindung weist die kapazitive Sensoreinheit mehrere kapazitive Annäherungssensoren auf.

Es können beispielsweise eine als Leiterschleife ausgeführte kapazitive Sensoreinheit um das Tastfeld sowie ein oder mehrere kapazitive Sensoreinheiten neben dem Tastfeld angeordnet sein. Ferner können auch mehrere kapazitive Sensoreinheiten das Tastfeld abdecken. Auf diese Weise kann der Bereich, in welchem die Annäherung des Benutzers detektiert werden soll, genau konfiguriert werden.

Ein weiterer Aspekt der Erfindung betrifft eine Anzeige- und Bedieneinheit mit einer Bedieneinheit, welche oben und im Folgenden beschrieben ist. Dabei ist das kapazitive Tastfeld als Berührungsbildschirm zum Anzeigen einer Information und zum Entgegennehmen der Benutzereingabe ausgeführt.

Das kapazitive Tastfeld kann somit als Berührungsbildschirm zum Darstellen von Information bzw. als Touchscreen ausgeführt sein. Beispielsweise kann die Bedieneinheit eine Bedieneinheit eines Fahrzeug-Audiosystems sein. Gleichzeitig können in diesem Beispiel Informationen zum Audiosystem dargestellt werden und es kann eine Benutzereingabe auf der Bedieneinheit durch Berührung oder Annäherung getätigt werden. Im Ruhezustand der Bedieneinheit kann das Sensorfeld des Berührungsbildschirms deaktiviert sein, wohingegen weiterhin Information auf dem Berührungsbildschirm dargestellt wird. Alternativ kann die Bildwiedergabe des Berührungsbildschirms im Ruhezustand deaktiviert sein. Auf diese Weise können auf dem Bedienelement Informationen dargestellt werden und Benutzereingaben erfolgen.

Ein weiterer Aspekt der Erfindung betrifft ein Fahrzeug mit einer Bedieneinheit, welche oben und im Folgenden beschrieben ist.

Die Bedieneinheit des Fahrzeugs kann einen niedrigen Ruhestrom aufweisen. Auf diese Weise kann die Bedieneinheit weiterhin auf eine Benutzereingabe reagieren, auch wenn der Motor des Fahrzeugs nicht läuft. Ferner kann das Fahrzeug ein Elektroauto sein. In diesem Fall kann die Akkuladung des Elektroautos länger halten, da die Bedieneinheit einen geringen Ruhestromverbrauch aufweist. Somit kann auch die Reichweite des Elektroautos erhöht werden.

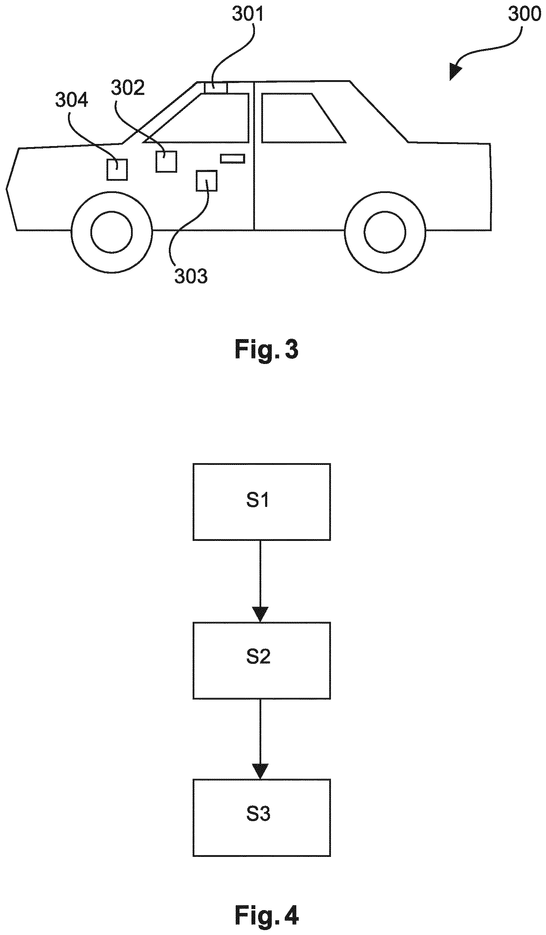

Beispielsweise ist ein solches Fahrzeug in Fig. 3 dargestellt.

Ein weiterer Aspekt der Erfindung betrifft ein Verfahren gemäß Anspruch. 9.

Die Schritte des Verfahrens können dabei in der genannten Reihenfolge erfolgen. Alternativ können die Schritte auch in einer anderen Reihenfolge oder parallel erfolgen. Dabei treffen die im Zusammenhang mit der Bedieneinheit beschriebenen Merkmale und Vorteile auch auf das Verfahren zu.

Die beschriebenen Ausführungsformen betreffen gleichermaßen eine Bedieneinheit, ein Fahrzeug und ein Verfahren, obwohl einzelne Ausführungsformen ausschließlich in Bezug zur Bedieneinheit, zum Fahrzeug oder zum Verfahren beschrieben werden. Synergetische Effekte können sich aus verschiedenen Kombinationen der Ausführungsformen ergeben, auch wenn diese im Folgenden nicht beschrieben werden.

Weitere Merkmale, Vorteile und Anwendungsmöglichkeiten der Erfindung ergeben sich aus der nachfolgenden Beschreibung der Ausführungsbeispiele und Figuren. Dabei bilden alle beschriebenen und/oder bildlich dargestellten Merkmale für sich und in beliebiger Kombination den Gegenstand der Erfindung auch unabhängig von ihrer Zusammensetzung in den einzelnen Ansprüchen oder deren Rückbezügen.

### Kurze Beschreibung der Figuren

Fig. 1 zeigt eine Bedieneinheit gemäß einem Ausführungsbeispiel der Erfindung.
Fig. 2 zeigt eine Bedieneinheit gemäß einem Ausführungsbeispiel der Erfindung.
Fig. 3 zeigt ein Fahrzeug gemäß einem Ausführungsbeispiel der Erfindung.
Fig. 4 zeigt ein Flussdiagramm eines Verfahrens gemäß einem Ausführungsbeispiel der Erfindung.

Dabei sind die Figuren schematisch und nicht maßstabsgetreu dargestellt.

### Detaillierte Beschreibung der Figuren

Ein anhand von Fig. 1 dargestelltes Ausführungsbeispiel der Erfindung betrifft eine Bedieneinheit 100 eines Fahrzeugs 300, welches ein kapazitives Tastfeld 101 zum Entgegennehmen einer Benutzereingabe 111, eine kapazitive Sensoreinheit 102 und eine erste Steuereinheit 103 aufweist. Dabei ist die kapazitive Sensoreinheit 102 zum Detektieren einer Annäherung eines Benutzers an das kapazitive Tastfeld 101 ausgeführt. Das kapazitive Tastfeld 101 ist ferner ausgeführt, eine Berührung 111 des kapazitiven Tastfeldes 101 durch den Benutzer oder die Annäherung des Benutzers an das kapazitive Tastfeld 101 zu detektieren. Ferner ist die erste Steuereinheit 103 dazu ausgeführt ist, das kapazitive Tastfeld 101 zu aktivieren, wenn die kapazitive Sensoreinheit 102 die Annäherung des Benutzers an das kapazitive Tastfeld detektiert.

Gemäß einem weiteren anhand von Fig. 1 dargestellten Ausführungsbeispiel der Erfindung weist die Bedieneinheit 100 ferner eine zweite Steuereinheit 104 für das Tastfeld 101 sowie eine Hauptsteuereinheit 105 für die Bedieneinheit 100 auf. Dabei weist die erste Steuereinheit 103 einen Eingang 107 für die kapazitive Sensoreinheit 102 auf. In diesem Ausführungsbeispiel ist die kapazitive Sensoreinheit 102 als Leiterschleife ausgeführt, die um das Tastfeld 101 herum angeordnet ist, d. h., das Tastfeld 101 ist innerhalb der Leiterschleife 102 angeordnet. Die kapazitive Sensoreinheit ist mittels der Verbindung 106, z. B. einem Leiter und/oder einer Funkverbindung, mit der ersten Steuereinheit 103 Verbunden. Die erste Steuereinheit 103 ist mittels der Verbindung 108 mit der Hauptsteuereinheit 105 verbunden und die Hauptsteuereinheit 105 ist mittels der Verbindung 109 mit der zweiten Steuereinheit 104 des Tastfelds 101 verbunden. Die zweite Steuereinheit 104 kann mehrere Eingänge für ein Sensorfeld des kapazitiven Tastfelds 101 aufweisen, welche in der Figur nicht dargestellt sind. Die Verbindung 110 zwischen dem Tastfeld 101 und der zweiten Steuereinheit kann ebenfalls mehrere Verbindungen zwischen dem Sensorfeld des Tastfelds 101 und der zweiten Steuereinheit beinhalten. Dabei sind die in den beschriebenen Ausführungsformen genannten Verbindungen zum Signaltransport ausgeführt. Beispielsweise handelt es sich dabei um Leiter- und/oder Funkverbindungen.

Wenn sich beispielsweise die Hand 111 des Benutzers dem Tastfeld 101 annähert, misst die kapazitive Sensoreinheit 102 eine Änderung der Kapazität. Diese Änderung der Kapazität wird von der ersten Steuereinheit 103 registriert. In diesem Fall sendet die erste Steuereinheit 103 ein erstes Aufwachsignal über die Verbindung 108 an die Hauptsteuereinheit 105. Die Hauptsteuereinheit 105 wiederum sendet über die Verbindung 109 ein zweites Aufwachsignal an die zweite Steuereinheit 104 des Tastfelds 101 weiter. Die Steuereinheit 104 sendet dann ein drittes Aufwachsignal an das Tastfeld 101 woraufhin das Tastfeld 101 aktiv wird und eine Benutzereingabe entgegennehmen kann. Die Hauptsteuereinheit 105 kann weitere Schritte veranlassen, die ausgeführt werden sollen, wenn das Tastfeld 101 aktiviert wird.

Im Ruhezustand bzw. für den Ruhezustand des Tastfelds ist die Hauptsteuereinheit ausgeführt 105 ein Stand-by-Signal an die zweite Steuereinheit 104 zu senden. Daraufhin deaktiviert die zweite Steuereinheit 104 das Tastfeld 101 bzw. versetzt das Tastfeld 101 in den Ruhemodus. Dies kann beispielsweise automatisch nach einer gewissen Zeit, in der keine Aktivität bzw. Benutzereingabe stattgefunden hat, erfolgen. Gegebenenfalls kann die zweite Steuereinheit 104 im Ruhemodus ebenfalls deaktiviert werden bzw. in den Ruhemodus versetzt werden.

Anhand von Fig. 2 ist eine Bedieneinheit gemäß einem weiteren Ausführungsbeispiel der Erfindung dargestellt. Gemäß diesem Ausführungsbeispiel weist die Bedieneinheit 200 mehrere kapazitive Sensoreinheiten 201, 202, 203 und 204 auf. Gemäß einem weiteren anhand von Fig. 2 beschriebenen Ausführungsbeispiel der Erfindung sind die kapazitiven Sensoreinheiten 201, 202, 203 und 204 außerhalb des Tastfelds 101 jeweils in der Nähe einer Ecke des Tastfelds 101 angeordnet. Das heißt in anderen Ausführungsbeispielen sind auch andere Anordnungen möglich. Die kapazitiven Sensoreinheiten 201, 202, 203 und 204 sind jeweils mit der ersten Steuereinheit 103 verbunden. Dazu weist die Steuereinheit vier Eingänge 210, 211, 212 und 213 auf, welche über Verbindungen 206, 207, 208 und 209 mit den kapazitiven Sensoreinheiten verbunden sind. Die erste Steuereinheit ist mittels einer Verbindung 214 mit einer zentralen Steuereinheit 205 verbunden. Die zentrale Steuereinheit 205 ist in diesem Ausführungsbeispiel als sogenannter System-Basis-Chip ausgeführt, welcher die Spannungsversorgung und Resetüberwachung für die Hauptsteuereinheit 105, für die zweite Steuereinheit 104 des Tastfelds 101 und für das Tastfeld 101 bereitstellt. Dafür ist die zentrale Steuereinheit 205 über eine erste Verbindung 215 zur Spannungsversorgung mit der Hauptsteuereinheit 105 verbunden. Ferner ist die zentrale Steuereinheit 205 zur Resetüberwachung mittels einer zweiten Verbindung 216 mit der Hauptsteuereinheit 105 verbunden und die Hauptsteuereinheit 105 ist mittels der Verbindung 109 mit der zweiten Steuereinheit 104 des Tastfelds 101 verbunden. Die zweite Steuereinheit 104 kann mehrere Eingänge für ein Sensorfeld des kapazitiven Tastfelds 101 aufweisen, welche in der Figur nicht dargestellt sind. Die Verbindung 110 zwischen dem Tastfeld 101 und der zweiten Steuereinheit kann ebenfalls mehrere Verbindungen zwischen dem Sensorfeld des Tastfelds 101 und der zweiten Steuereinheit beinhalten.

Wenn sich der Benutzer zur Benutzereingabe dem Tastfeld 101 nähert, so messen beispielsweise eine oder mehrere der kapazitiven Sensoreinheiten 201, 202, 203 und 204 eine Änderung der Kapazität. Die erste Steuereinheit 103 registriert in diesem Fall die Änderung der Kapazität der jeweiligen Sensoreinheit 201, 202, 203 und/oder 204 und sendet ein erstes Aufwachsignal an die zentrale Steuereinheit 205. In diesem Fall versorgt die zentrale Steuereinheit 205 die Hauptsteuereinheit 105 mit der Versorgungsspannung und sendet ein zweites Aufwachsignal an die Hauptsteuereinheit 105 der Bedieneinheit. Die Bedieneinheit sendet ein drittes Aufwachsignal an die zweite Steuereinheit 104 des Tastfelds 101, woraufhin diese das Tastfeld 101 aktiviert. Um das Tastfeld 101 in den Ruhezustand zu versetzten, sendet die Hauptsteuereinheit 105 ein Stand-by-Signal an die zweite Steuereinheit des Tastfelds 101, woraufhin die zweite Steuereinheit 104 das Tastfeld 101 deaktiviert bzw. in den Ruhezustand versetzt. Anschließend deaktiviert die Hauptsteuereinheit 105 die Versorgungsspannung, welche von der zentralen Steuereinheit 205 bereitgestellt wird, so dass die zweite Steuereinheit 104, und das Tastfeld 101 keinen Strom mehr verbrauchen.

In Fig. 3 ist ein Fahrzeug 300 mit einer Bedieneinheit gemäß einem weiteren Ausführungsbeispiel der Erfindung dargestellt. Das Fahrzeug weist eine Dachbedieneinheit 301, eine Radio-, Klima- und Navigationsbedieneinheit 302 und eine Fensterheberbedieneinheit 303 auf, welche gemäß den in der vorliegenden Anmeldung beschriebenen Ausführungsformen und Ausführungsbeispielen genannten Bedieneinheiten ausgeführt sind. Dabei werden die Bedieneinheiten 301, 302 und 303 von einer zentralen Steuereinheit 304 gesteuert. Alternativ können die Bedieneinheiten 301, 302 und 303 jeweils eigene Steuereinheiten aufweisen, welche nicht zentral über die zentrale Steuereinheit 304 gesteuert werden, auch wenn dies in diesem Ausführungsbeispiel nicht explizit dargestellt ist. Ferner kann jede der Bedieneinheiten 301, 302 und 303 mittels der im Kontext der vorliegenden Erfindung beschriebenen Mechanismen eine Annäherung eines Benutzers erkennen und daraus funktionsspezifische Aktivitäten ableiten.

In Fig. 4 ist ein Flussdiagramm eines Verfahrens zum Betreiben einer Bedienvorrichtung mit einem kapazitiven Tastfeld in einem Fahrzeug gemäß einem Ausführungsbeispiel der Erfindung gezeigt. Das Verfahren weist den Schritt S1 des Detektierens einer Annäherung eines Benutzers an das kapazitive Tastfeld mittels einer kapazitiven Sensoreinheit der Bedienvorrichtung auf. Ferner erfolgt gemäß dem Verfahren der Schritt S2 des Aktivierens des kapazitiven Tastfeldes durch eine erste Steuereinheit, wenn die kapazitive Sensoreinheit die Annäherung des Benutzers an das kapazitive Tastfeld detektiert. Das Verfahren weist ferner den Schritt S3 des Entgegennehmens einer Benutzereingabe durch Detektieren einer Berührung des kapazitiven Tastfeldes durch den Benutzer oder durch Detektieren der Annäherung des Benutzers an das kapazitive Tastfeld durch das kapazitive Tastfeld auf.

Ergänzend sei darauf hinzuweisen, dass "umfassend" oder "aufweisend" keine anderen Elemente ausschließt und "ein" oder "einer" keine Vielzahl ausschließt. Ferner sei darauf hingewiesen, dass Merkmale, die mit Verweis auf eines der obigen Ausführungsbeispiele oder Ausführungsformen beschrieben worden sind, auch in Kombination mit anderen Merkmalen anderer oben beschriebener Ausführungsbeispiele oder Ausführungsformen verwendet werden können. Bezugszeichen in den Ansprüchen sind nicht als Einschränkungen anzusehen. Der Schutzumfang wird durch die Ansprüche definiert.

## Patentansprüche

1. Bedieneinheit (100) eines Fahrzeugs (300), die Bedieneinheit aufweisend:
ein kapazitives Tastfeld (101) zum Entgegennehmen einer Benutzereingabe;
eine kapazitive Sensoreinheit (102, 201-204); und
eine erste Steuereinheit (103);
wobei die kapazitive Sensoreinheit(102, 201-204) zum Detektieren einer Annäherung eines Benutzers an das kapazitive Tastfeld ausgeführt ist;
wobei das kapazitive Tastfeld (101) ausgeführt ist, eine Berührung des kapazitiven Tastfeldes (101) durch den Benutzer oder die Annäherung des Benutzers an das kapazitive Tastfeld (101)zu detektieren; und
wobei die erste Steuereinheit (103) dazu ausgeführt ist, das kapazitive Tastfeld (101) zu aktivieren, wenn die kapazitive Sensoreinheit (102, 201-204) die Annäherung des Benutzers an das kapazitive Tastfeld (101) detektiert,
**dadurch gekennzeichnet, dass**
die Bedieneinheit eine zweite Steuereinheit (104) zum Steuern des kapazitiven Tastfeldes aufweist;
wobei die erste Steuereinheit dazu ausgeführt ist, zum Aktivieren des kapazitiven Tastfeldes ein Aktivierungssignal an die zweite Steuereinheit zu senden und die zweite Steuereinheit(104) zu aktivieren; und
wobei die zweite Steuereinheit dazu ausgeführt ist, das kapazitive Tastfeld nach Empfang des Aktivierungssignals zu aktivieren.

2. Bedieneinheit nach Anspruch 1,
wobei die Bedieneinheit dazu ausgeführt ist, in einem Ruhezustand der Bedieneinheit das kapazitive Tastfeld zu deaktivieren; und
wobei die Bedieneinheit ausgeführt ist, die kapazitive Sensoreinheit und die erste Steuereinheit aktiviert zu lassen.

3. Bedieneinheit nach einem der vorangehenden Ansprüche,
wobei die erste Steuereinheit und die kapazitive Sensoreinheit zusammen mit einem Ruhestrom betrieben werden, der kleiner oder gleich 100 µA ist; und
wobei das kapazitive Tastfeld einen Stromverbrauch aufweist, der größer oder gleich 1 mA ist.

4. Bedieneinheit nach einem der vorangehenden Ansprüche,
wobei die kapazitive Sensoreinheit als Leiterschleife ausgeführt ist.

5. Bedieneinheit nach Anspruch 4,
wobei das kapazitive Tastfeld innerhalb der Leiterschleife angeordnet ist.

6. Bedieneinheit nach einem der vorangehenden Ansprüche,
wobei die kapazitive Sensoreinheit mehrere kapazitive Annäherungssensoren aufweist.

7. Anzeige- und Bedieneinheit mit einer Bedieneinheit nach einem der vorangehenden Ansprüche,
wobei das kapazitive Tastfeld als Berührungsbildschirm zum Anzeigen einer Information und zum Entgegennehmen der Benutzereingabe ausgeführt ist.

8. Fahrzeug (300) mit einer Bedieneinheit nach einem der Ansprüche 1 bis.

9. Verfahren zum Betreiben einer Bedienvorrichtung mit einem kapazitiven Tastfeld in einem Fahrzeug, das Verfahren aufweisend die Schritte:
Detektieren einer Annäherung eines Benutzers an das kapazitive Tastfeld mittels einer kapazitiven Sensoreinheit der Bedienvorrichtung (S1);
Aktivieren des kapazitiven Tastfeldes durch eine erste Steuereinheit(103) über eine zweite Steuereinheit(104), wenn die kapazitive Sensoreinheit die Annäherung des Benutzers an das kapazitive Tastfeld detektiert (S2); und
Entgegennehmen einer Benutzereingabe durch Detektieren einer Berührung des kapazitiven Tastfeldes durch den Benutzer oder durch Detektieren der Annäherung des Benutzers an das kapazitive Tastfeld durch das kapazitive Tastfeld (S3).

## Claims

1. Operating unit (100) of a vehicle (300), the operating unit comprising:
a capacitive touch panel (101) for receiving a user input;
a capacitive sensor unit (102, 201-204); and
a first control unit (103);
wherein the capacitive sensor unit (102, 201-204) is designed for detecting an approach of a user to the capacitive touch panel;
wherein the capacitive touch panel (101) is designed to detect a touch of the capacitive touch panel (101) by the user or the approach of the user to the capacitive touch panel (101); and
wherein the first control unit (103) is designed to activate the capacitive touch panel (101) if the capacitive sensor unit (102, 201-204) detects the approach of the user to the capacitive touch panel (101),
**characterized in that**
the operating unit has a second control unit (104) for controlling the capacitive touch panel;
wherein the first control unit is designed to send an activation signal to the second control unit in order to activate the capacitive touch panel and to activate the second control unit (104); and
wherein the second control unit is designed to activate the capacitive touch panel after receiving the activation signal.

2. Operating unit according to Claim 1,
wherein the operating unit is designed to deactivate the capacitive touch panel in a quiescent state of the operating unit; and
wherein the operating unit is designed to keep the capacitive sensor unit and the first control unit activated.

3. Operating unit according to any of the preceding claims,
wherein the first control unit and the capacitive sensor unit are operated jointly with a quiescent current that is less than or equal to 100 µA; and
wherein the capacitive touch panel has a current consumption that is greater than or equal to 1 mA.

4. Operating unit according to any of the preceding claims,
wherein the capacitive sensor unit is designed as a conductor loop.

5. Operating unit according to Claim 5,
wherein the capacitive touch panel is arranged within the conductor loop.

6. Operating unit according to any of the preceding claims,
wherein the capacitive sensor unit comprises a plurality of capacitive proximity sensors.

7. Display and operating unit comprising an operating unit according to any of the preceding claims,
wherein the capacitive touch panel is designed as a touch screen for displaying information and for receiving the user input.

8. Vehicle (300) comprising an operating unit according to any of Claims 1 to 7.

9. Method for operating an operating device comprising a capacitive touch panel in a vehicle, the method comprising the following steps:
detecting an approach of a user to the capacitive touch panel by means of a capacitive sensor unit of the operating device (S1);
activating the capacitive touch panel by means of a first control unit (103) via a second control unit (104) if the capacitive sensor unit detects the approach of the user to the capacitive touch panel (S2); and
receiving a user input by detecting a touch of the capacitive touch panel by the user or by detecting the approach of the user to the capacitive touch panel by means of the capacitive touch panel (S3).

## Revendications

1. Unité d'opération (100) d'un véhicule (300), l'unité d'opération comprenant :
un clavier capacitif (101) destiné à recevoir une saisie d'utilisateur ;
une unité de détection capacitive (102, 201-204) ; et
une première unité de commande (103) ;
l'unité de détection capacitive (102, 201-204) étant conçue pour détecter une approche d'un utilisateur vers le clavier capacitif ;
le clavier capacitif (101) étant conçu pour détecter un toucher du clavier capacitif (101) par l'utilisateur ou l'approche de l'utilisateur vers le clavier capacitif (101) ; et
la première unité de commande (103) étant conçue pour activer le clavier capacitif (101) lorsque l'unité de détection capacitive (102, 201-204) détecte l'approche de l'utilisateur vers le clavier capacitif (101),
**caractérisée en ce que**
l'unité d'opération possède une deuxième unité de commande (104) destinée à commander le clavier capacitif ;
la première unité de commande étant conçue pour, en vue d'activer le clavier capacitif, envoyer un signal d'activation à la deuxième unité de commande et activer la deuxième unité de commande (104) ; et
la deuxième unité de commande étant conçue pour activer le clavier capacitif après la réception du signal d'activation.

2. Unité d'opération selon la revendication 1,
l'unité d'opération étant conçue pour désactiver le clavier capacitif dans un état de repos de l'unité d'opération ; et
l'unité d'opération étant conçue pour laisser activées l'unité de détection capacitive et la première unité de commande.

3. Unité d'opération selon l'une des revendications précédentes,
la première unité de commande et l'unité de détection capacitive fonctionnant ensemble avec un courant de repos qui est inférieur ou égal à 100 µA ; et
le clavier capacitif possédant une consommation de courant qui est égale ou supérieure à 1 mA.

4. Unité d'opération selon l'une des revendications précédentes, l'unité de détection capacitive étant réalisée sous la forme d'une boucle conductrice.

5. Unité d'opération selon la revendication 4, le clavier capacitif étant disposé à l'intérieur de la boucle conductrice.

6. Unité d'opération selon l'une des revendications précédentes, le clavier capacitif possédant plusieurs détecteurs d'approche capacitifs.

7. Unité d'affichage et d'opération comprenant une unité d'opération selon l'une des revendications précédentes,
le clavier capacitif étant réalisé sous la forme d'un écran tactile destiné à afficher une information et à recevoir une saisie d'utilisateur.

8. Véhicule (300) comprenant une unité d'opération selon l'une des revendications 1 à 7.

9. Procédé pour faire fonctionner un dispositif d'opération pourvu d'un clavier capacitif dans un véhicule, le procédé comprenant les étapes suivantes :
détection d'une approche d'un utilisateur vers le clavier capacitif au moyen d'une unité de détection capacitive du dispositif d'opération (S1) ;
activation du clavier capacitif par une première unité de commande (103) par le biais d'une deuxième unité de commande (104) lorsque l'unité de détection capacitive détecte l'approche de l'utilisateur vers le clavier capacitif (S2) ; et
réception d'une saisie d'utilisateur par détection d'un toucher du clavier capacitif par l'utilisateur ou par détection de l'approche de l'utilisateur vers le clavier capacitif par le clavier capacitif (S3).
